# EUROPÄISCHE PATENTSCHRIFT

(11) **EP 3 580 372 B1**
(45) Veröffentlichungstag und Bekanntmachung des Hinweises auf die Patenterteilung: **06.10.2021**
(21) Anmeldenummer: 18706206.2
(22) Anmeldetag: 02.02.2018
(51) Int. Cl.: C23C 28/04, C23C 16/30, C23C 16/36

(54) **HARTSTOFFBESCHICHTETE KÖRPER AUS METALL, HARTMETALL, CERMET ODER KERAMIK UND VERFAHREN ZUR HERSTELLUNG DERARTIGER KÖRPER**
ARTICLES CONSISTING OF METAL, HARD METAL, CERMET OR CERAMIC AND COATED WITH A HARD MATERIAL, AND METHOD FOR PRODUCING SUCH ARTICLES
CORPS EN MÉTAL, EN MÉTAL DUR, EN CERMET OU EN CÉRAMIQUE REVÊTUS PAR UN MATÉRIAU DUR AINSI QUE PROCÉDÉ POUR LA FABRICATION DE TELS CORPS

(30) Priorität: 10.02.2017 DE 102017102642
(43) Veröffentlichungstag der Anmeldung: 18.12.2019
(73) Patentinhaber: Fraunhofer-ges. zur Förderung der Angewandten Forschung E.V., 80686 München (DE)
(72) Erfinder: ENDLER, Ingolf, 01640 Coswig (DE); HÖHN, Mandy, OT Pesterwitz 01705 Freital (DE)
(74) Vertreter: Rauschenbach, Marion
(86) Internationale Anmeldenummer: PCT/EP2018/052635
(87) Internationale Veröffentlichungsnummer: WO 2018/146013

(56) Entgegenhaltungen:
- WO-A1-2013/083447
- DE-A1-102006 019 866
- JP-A- 2004 114 219
- KUO D-H ET AL: "A new class of Ti-Si-C-N coatings obtained by chemical vapor deposition - part II: low-temperature process", THIN SOLID FILMS, Bd. 394, Nr. 1-2, 14. August 2001 (2001-08-14), Seiten 80-88, XP004300437, ELSEVIER, AMSTERDAM [NL] ISSN: 0040-6090, DOI: 10.1016/S0040-6090(01)00878-1

## Beschreibung

Die Erfindung betrifft hartstoffbeschichtete Körper aus Metall, Hartmetall, Cermet oder Keramik sowie ein Verfahren zur Herstellung derartiger Körper. Die erfindungsgemäßen Hartstoffschichten können beispielsweise als Verschleißschutzschichten für Schneidwerkzeuge, als Schutzschichten für Turbinenschaufeln oder als Diffusionsbarrieren in der Mikroelektronik eingesetzt werden.

Hartmetall- und Keramikwerkzeuge weisen heute verschiedene Verschleißschutzschichten auf, die die Standzeit der Werkzeuge entscheidend erhöhen. Durch ihre besonderen Eigenschaften, wie beispielsweise eine hohe Härte und eine gute Oxidations- und Temperaturbeständigkeit, wird das Werkzeug geschützt und die Leistungsfähigkeit deutlich erhöht.

Aus dem Stand der Technik sind bereits eine Vielzahl Hartstoffschichten bekannt. Diese unterscheiden sich hinsichtlich der Zusammensetzung, der Struktur und den Eigenschaften.

Als Verschleißschutzschichten sind beispielsweise Hartstoffschichten bekannt, die aus TiSiCN oder aus TiSiCNO bestehen, wobei zur Herstellung PVD- oder plasmagestützte CVD-Verfahren eingesetzt werden.

Aus der JP 2004 074 361 A ist eine Oberflächenbeschichtung bekannt, die auf einem Substrat angeordnet ist, wobei die Oberflächenbeschichtung aus einem Nitrid, Karbonitrid, Oxynitrid oder Oxykarbonitrid von (MₓSi_{y}) besteht. M ist Ti, Al, Cr, Zr, V, Hf, Nb, Mo, W, Ta und es gilt 0,1 ≦ y ≦ 0,8, wobei x + y = 1 ist. Das beschichtete Hartstoffwerkzeug weist eine Härte der Oberflächenbeschichtung auf, die sich kontinuierlich oder schrittweise von der Substratoberfläche zur Oberfläche der Beschichtung ändert.

Aus der JP 2004 114 219 A ist eine Oberflächenbeschichtung bekannt, die auf einem Substrat angeordnet ist, wobei die Oberflächenbeschichtung aus (TiₓSi_{y})(CₐN_{b}O_{c}), gebildet ist und eine Zusammensetzung 0,1 ≤ y ≤ 0,8 bei x + y = 1, 0 ≤ a ≤ 0,6 und 0 ≤ b ≤ 1,0 und 0 ≤ c ≤ 0,5 bei a + b + c = 1 aufweist. Die Menge an C in der Oberflächenschicht steigt von Oberflächenseite des Substrates zur Oberfläche der Beschichtung kontinuierlich an.

Aus der EP 1 382 709 A1 ist eine mehrlagige Beschichtung bekannt, bei der eine Einzellage durch eine TiSiCN- oder TiSiCNO-Schicht gebildet wird, die eine Nanokompositstruktur aufweist. Diese Schicht besteht aus einer kubischen TiSiCN- oder TiSiCNO-Phase mit einer Kristallitgröße zwischen 0,1 nm und 10 nm sowie einem amorphen Nitrid, Karbid, Karbonitrid, Oxynitrid, Oxykarbonitrid von Si. Alle Schichten werden mittels PVD hergestellt.

Allerdings ist bekannt, dass die mittels PVD-Verfahren hergestellten TiSiCNO-Schichten eine geringe Härte von maximal 10 GPa aufweisen (Zheng, Y. et al.: "Evaluation of mechanical properties of Ti(Cr)Si(O)N coated cermented carbide tools", Vacuum 90 (2013) 50). Die Ursache für die geringe Härte in den genannten Schichten ist darin zu finden, dass der hohe Sauerstoffeinbau zur Ausbildung kristalliner Ti-O-Verbindungen und zu einer geringen Härte führt, andererseits dadurch eine gute Biokompatibilität erreicht wird.

Aus der WO 2008 129 528 A2 ist ein beschichtetes Metallsubstrat bekannt, dass zumindest eine Schicht aus einem Titan-basierten Hartstoff aufweist, der mit mindestens einem Legierungselement aus der Liste von Chrom, Vanadium und Silizium legiert ist. Die Gesamtmenge der Legierungselemente liegt zwischen 1% und 50% des Metallgehaltes, wobei die Schicht eine allgemeine Formel (Ti_{100-a-b- c}CrₐV_{b}Si_{c})CₓN_{y}O_{z} hat. Die Schicht wird mittels CVD-Verfahren hergestellt. Bei dem angegeben CVD-Verfahren handelt es sich um einen Mitteltemperaturprozess, bei dem die Legierungselemente Cr, V, Si immer in geringer Menge zugegeben werden. Zudem ist angegeben, dass der Partialdruck des Siliziumchlorides 0,1% bis 30% von dem des Metallchlorides TiCl₄ beträgt.

Aus der DE 10 2011 087 715 A1 sind hartstoffbeschichtete Körper aus Metall, Hartmetall, Cermet oder Keramik bekannt, die mit einer TiSiCN-Kompositschicht oder mit einem mehrlagigen Schichtsystem beschichtet sind, das mindestens eine TiSiCN-Kompositschicht enthält, wobei die TiSiCN-Kompositschicht eine nanokristalline Phase aus TiCₓN₁₋ₓ und eine zweite Phase aus amorphem SiCₓN_{y} enthält und mittels thermischem CVD-Verfahren ohne zusätzliche Plasmaanregung hergestellt ist. Zudem ist ein Verfahren zur Herstellung derartiger hartstoffbeschichteter Körper aus Metall, Hartmetall, Cermet oder Keramik angegeben, bei dem die TiSiCN-Kompositschicht in einer Gasmischung, die ein oder mehrere Titanhalogenide, einen oder mehrere siliciumhaltige Precursoren, Wasserstoff, sowie reaktive Verbindungen mit Kohlenstoff- und Stickstoffatomen und/oder Stickstoffverbindungen und/oder Kohlenwasserstoffen und/oder inerte Edelgase enthält, mit einem thermischen CVD-Prozess bei Temperaturen zwischen 700 °C und 1100 °C und bei Drücken zwischen 10 Pa und 101,3 kPa ohne zusätzliche Plasmaanregung auf dem Körper abgeschieden wird.

Nachteilig bei den bekannten Lösungen ist es, das der Sauerstoffeinbau in TiSiCN-Schichten zur Verringerung der Härte und Oxidationsbeständigkeit und damit zu einer unzureichenden Verschleißbeständigkeit führt und die Verfahren zur Erzeugung von Hartstoffschichten aufwendig und kostenintensiv sind. Bei den bisherigen CVD-Verfahren erfolgt der Sauerstoffeinbau außerdem unkontrolliert.

Der Erfindung liegt die Aufgabe zugrunde, Hartstoffschichten bereitzustellen, die neben einer hohen Härte und Oxidationsbeständigkeit eine exzellente Verschleißfestigkeit aufweisen. Eingeschlossen in diese Aufgabe ist die Bereitstellung eines Verfahrens, das auch unter industriellen Bedingungen kostengünstig eine Erzeugung derartiger Hartstoffschichten ermöglicht.

Die Aufgabe wird mit den Merkmalen der Patentansprüche gelöst, wobei die Erfindung auch Kombinationen der einzelnen abhängigen Patentansprüche im Sinne einer UND-Verknüpfung mit einschließt, solange sie sich nicht gegenseitig ausschließen.

Erfindungsgemäß werden hartstoffbeschichtete Körper aus Metall, Hartmetall, Cermet oder Keramik bereitgestellt, die mittels eines thermischen CVD-Verfahrens ohne Plasmaanregung mit einem ein- oder mehrlagigen Schichtsystem beschichtet sind, wobei das ein- oder mehrlagige Schichtsystem mindestens eine Nanokompositschicht mit einer Gesamtzusammensetzung (TiₓSi_{y})(CₐN_{b}O_{c}) mit 0,7 < x ≤ 0,99 und 0,01 ≤ y < 0,3 und 0,4 < a < 0,9 und 0,1 < b < 0,6 und 0,01 < c ≤ 0,1 enthält, wobei die Nanokompositschicht eine erste nanokristalline Phase aus kubischem Titanoxykarbonitrid mit einer Kristallitgröße von 10 nm bis 20 nm und eine zweite amorphe Phase aus Siliziumoxykarbonitrid oder Siliziumoxykarbid aufweist, und wobei die Nanokompositschicht einen Chlorgehalt zwischen 0,001 und 1 At.-% aufweist.

Vorteilhafterweise sind mehrere Nanokompositschichten angeordnet.

Ebenfalls ist vorteilhaft, wenn die hartstoffbeschichteten Körper die ein oder mehreren Nanokompositschichten einen Gradienten hinsichtlich des Si/Ti-Atomverhältnisses aufweisen.

In einer vorteilhaften Ausführung besitzt mindestens eine Nanokompositschicht eine lamellare Struktur, wobei vorteilhafterweise die Schicht mit lamellarer Struktur Lamellen mit einer Dicke zwischen 50 nm und 500 nm aufweist. Auch ist vorteilhaft, wenn die Schicht mit lamellarer Struktur Lamellen mit unterschiedlichen Si/Ti-Atomverhältnissen aufweist.

Ebenso ist vorteilhaft, wenn die Nanokompositschicht eine Härte von 3000 HV bis 4000 HV, und ganz besonders vorteilhaft eine Härte von 3300 HV bis 3600 HV aufweist.

In einer vorteilhaften Ausführung der hartstoffbeschichteten Körper weist die Nanokompositschicht ein Schichtdicke von 1 µm bis 10 µm, und ganz besonders vorteilhaft eine Schichtdicke von 4 µm bis 7 µm auf.

Vorteilhaft ist auch, wenn eine oder mehrere Deckschichten und/oder Anbindungsschichten vorhanden sind, wobei vorteilhafterweise die Deckschichten und/oder Anbindungsschichten aus einem oder mehreren Nitriden, Karbiden, Karbonitriden, Oxynitriden, Oxykarbiden, Oxykarbonitriden, Oxiden von Ti, Hf, Zr, Cr und/oder Al oder Mischphasen dieser Elemente bestehen.

Erfindungsgemäß wird ein Verfahren zur Herstellung hartstoffbeschichteter Körper aus Metall, Hartmetall, Cermet oder Keramik bereitgestellt, bei dem mittels eines thermischen CVD-Verfahrens ohne Plasmaanregung mindestens eine (TixSiy)(CaNbOc)-Nanokompositschicht in einer Gasmischung aus TiCl₄, einem oder mehreren Siliziumchloriden, CH₃CN, H₂, CO und/oder CO₂ und bei Temperaturen zwischen 700°C und 950°C und bei Drücken zwischen 0,1 kPa und 0,1 MPa abgeschieden wird, wobei ein Atomverhältnis Si/Ti der Silizium- und Titanchloride in der Gasphase größer 1 gewählt wird.

Vorteilhafterweise wird der Gasmischung N₂ zugegeben.

Mit der erfindungsgemäßen Lösung wird eine Hartstoffbeschichtung für Körper aus Metall, Hartmetall, Cermet oder Keramik bereitgestellt, die neben einer hohen Härte und Oxidationsbeständigkeit eine exzellente Verschleißfestigkeit aufweist. Die erfindungsgemäße Hartstoffbeschichtung wird mittels thermischen CVD-Verfahren ohne Plasmaanregung hergestellt, wodurch auch unter industriellen Bedingungen kostengünstig eine Erzeugung derartiger hartstoffbeschichteter Körper möglich wird.

Mit dem thermischen CVD-Verfahren ohne Plasmaanregung wird auf den Körpern aus Metall, Hartmetall, Cermet oder Keramik ein ein- oder mehrlagiges Schichtsystem abgeschieden, wobei das ein- oder mehrlagige Schichtsystem mindestens eine Nanokompositschicht mit einer Gesamtzusammensetzung (TiₓSi_{y})(CₐN_{b}O_{c}) mit 0,7 < x ≤ 0,99 und 0,01 ≤ y < 0,3 und 0,4 < a < 0,9 und 0,1 < b < 0,6 und 0,01 < c ≤ 0,1 aufweist.

Die Nanokompositschicht weist eine erste nanokristalline Phase aus kubischem Titanoxykarbonitrid auf, wobei die Kristallite in einer Größe von 10 nm bis 20 nm vorliegen. Zudem weist die erfindungsgemäße Nanokompositschicht eine zweite amorphe Phase aus Siliziumoxykarbonitrid oder Siliziumoxykarbid auf.

Mit dem Vorliegen zweier unterschiedlicher Phasen in der Nanokompositschicht, nämlich der nanokristallinen Phase aus kubischem Titanoxykarbonitrid und der zweiten amorphen Phase aus Siliziumoxykarbonitrid oder Siliziumoxykarbid, werden hinsichtlich Verschleißbeständigkeit und Oxidationsbeständigkeit besonders gute Eigenschaften erzielt.

Während diese zweiphasige Nanokompositstruktur zu besonders hohen Härtewerten der Nanokompositschicht führt, wird durch das Vorhandensein der amorphen Phase aus Siliziumoxykarbonitrid oder Siliziumoxykarbid eine wesentlich verbesserte Oxidationsbeständigkeit erreicht.

Zudem wird aufgrund des geringen Chlorgehaltes zwischen 0,001 und 1 At.-% in der Nanokompositschicht eine Degradierung der Nanokompositschicht vermieden. Vorteilhafterweise können die hartstoffbeschichteten Körper auch mehrere Nanokompositschichten aufweisen, wobei es möglich ist, dass entweder nur eine der einzelnen Nanokompositschichten für sich einen Gradienten hinsichtlich des Si/Ti-Atomverhältnisses aufweist. Möglich ist aber auch, dass die gesamte Nanokompositschicht, die aus mehreren einzelnen Nanokompositschichten bestehen kann, einen Gradienten hinsichtlich des Si/Ti-Atomverhältnisses aufweist. Durch die Berücksichtigung eines Gradienten hinsichtlich des Si/Ti-Atomverhältnisses in mindestens einer Nanokompositschicht wird erreicht, dass die Verschleißeigenschaften der hartstoffbeschichtete Körper individuell abgestimmt und damit beispielsweise die Standzeit der hartstoffbeschichteten Körper wesentlich verbessert ist.

Zusätzlich verbesserte mechanische Eigenschaften werden dann erreicht, wenn mindestens eine Nanokompositschicht eine lamellare Struktur aufweist, wobei die Lamellen eine Dicke von 50 nm bis 500 nm und unterschiedliche Si/Ti-Atomverhältnis aufweisen.

Der Vorteil derartiger lamellarer Strukturen in mindestens einer Nanokompositschicht besteht darin, dass die Rissausbreitung in der Nanokompositschicht behindert wird. Dadurch wird beispielsweise die Standzeit der Verschleißschutzschicht und des Werkzeuges wesentlich verbessert.

Mit der erfindungsgemäßen nanokristallinen Struktur der Hartstoffschicht sowie dem gezielten Einsatz von CO und/oder CO₂ werden besonders hohe Härtewerte von 3000 HV [0,01] bis 4000 HV [0,01], insbesondere von 3300 HV [0,01] bis 3600 HV [0,01] erreicht. Zudem konnte durch den Einsatz der speziellen sauerstoffhaltigen Precusoren und dem Einsatz des erfindungsgemäßen thermischen CVD-Verfahrens ohne Plasmaanregung erreicht werden, dass die nanokristalline Phase aus kubischem Titanoxykarbonitrid in einer vorteilhaften Ausgestaltung eine Kristallitgröße von 10 nm bis 20 nm aufweist.

Die Nanokompositschicht weist vorteilhafterweise eine Schichtdicke von 1 µm bis 10 µm auf und in besonders vorteilhafter Ausführung eine Schichtdicke von 4 µm bis 7 µm. Durch das erfindungsgemäße thermische CVD-Verfahren ohne Plasmaanregung und den damit verbundenen Prozessparametern während des Beschichtens der Körper aus Metall, Hartmetall, Cermet oder Keramik ist es möglich, derart vorteilhafte Schichtdicken herzustellen, die auf das jeweilige Einsatzgebiet und die Anwendung individuell abgestimmt werden. Zudem ist es möglich, durch das erfindungsgemäße Verfahren auch komplizierte Formen, Hinterschneidungen, Bohrungen und schwer erreichbare Bereiche der Körper mit der erfindungsgemäßen Nanokompositschicht zu beschichten, wodurch ein wesentlich breiteres Einsatzgebiet ermöglicht wird.

Besonders vorteilhaft ist es, wenn zwischen zu beschichtendem Körper und erfindungsgemäßer Nanokompositschicht eine oder mehrere Anbindungsschichten vorhanden sind und/oder auf der Nanokompositschicht eine oder mehrere Deckschichten aufgebracht sind. Durch die Verwendung einer oder mehrerer Anbindungsschichten wird insbesondere eine wesentlich bessere Haftung der erfindungsgemäßen Nanokompositschicht auf dem Körper aus Metall, Hartmetall, Cermet oder Keramik realisiert. Das Aufbringen einer oder mehrerer Deckschichten ermöglicht eine weitere Steigerung der Oxidationsbeständigkeit oder eine Herabsetzung der Reibung zwischen Schicht und Werkstück, wodurch beispielsweise eine wesentlich verbesserte Standzeit der Verschleißschutzschicht erreicht wird. Vorteilhafterweise bestehen die Deckschichten und/oder Anbindungsschichten aus einem oder mehreren Nitriden, Karbiden, Karbonitriden, Oxynitriden, Oxykarbiden, Oxykarbonitriden, Oxiden von Ti, Hf, Zr, Cr und/oder Al oder Mischphasen dieser Elemente.

Erfindungsgemäß werden die TiSiCNO-Nanokompositschichten auf Körpern aus Metall, Hartmetall, Cermet oder Keramik bereitgestellt, die dadurch besonders vorteilhafte Eigenschaften aufweisen. Erreicht wird dies durch das erfindungsgemäße thermische CVD-Verfahren ohne Plasmaanregung, bei dem mindestens eine (TiₓSi_{y})(CₐN_{b}O_{c})-Nanokompositschicht in einer Gasmischung aus TiCl₄, einem oder mehreren Siliziumchloriden, CH₃CN, H₂, CO und/oder CO₂ und bei Temperaturen zwischen 700°C und 950°C und bei Drücken zwischen 0,1 kPa und 0,1 MPa abgeschieden wird, wobei ein Atomverhältnis Si/Ti der Silizium- und Titanchloride in der Gasphase größer 1 gewählt wird.

Gegenüber bekannten TiSiCN-Nanokompositschichten wird durch den gezielten Einbau von Sauerstoff unter Verwendung eines Gaszusatzes aus CO und/oder CO₂ eine Verringerung der Korngröße der kubischen Titankarbonitrid-Phase unter gleichzeitiger Umwandlung in Titanoxykarbonitrid erreicht.

Überraschenderweise konnte festgestellt werden, dass beispielsweise durch die besondere Auswahl der sauerstoffhaltigen Precursoren CO und/oder CO₂ in Verbindung mit den speziellen Verfahrensbedingungen ein gezielter Einbau von Sauerstoff in die zweite amorphe Phase erreicht und dadurch die Struktur der Nanokompositschicht wesentlich beeinflusst wird. Damit wird erreicht, dass bereits bei geringen Si-Gehalten die Kristallitgröße der nanokristallinen Phase wesentlich verringert wird, was zu einem besonders feinen Gefüge und erheblich verbesserten mechanischen Eigenschaften der Verschleißschutzschicht führt.

Dies zeigen exemplarisch die in der Tabelle dargestellten Ergebnisse von mittels CVD-Verfahren durchgeführten Beschichtungen und Experimente.

| Abscheidungstemperatur (°C) | Druck (kPa) | SiCl₄/TiCl₄-Verhältnis | CO-Zusatz | Härte HV[0.01] | Kristallitgröße (nm) |
|---|---|---|---|---|---|
| 850 | 6 | 2,45 | kein | 3670 | 28 |
| 850 | 6 | 2,45 | 0,3 Vol.-% | 3970 | 18 |

Da bei CVD-Prozessen mit derartig komplexen Gasmischungen nicht vorhersagbar ist, wie der Einbau von O bei der Verwendung der sauerstoffhaltigen Precursoren CO bzw. CO₂ in die mehrphasige Nanokompositschicht erfolgt, wurden spektroskopische Untersuchungen zur Bestimmung der Bindungsverhältnisse durchgeführt.

Die Ausbildung von Ti-O- und Si-O-Bindungen konnte mittels XPS-Spektroskopie durch Analyse der O1s- und Si2p-Spektren nachgewiesen werden. Bei der erfindungsgemäßen (TiₓSi_{y})(CₐN_{b}O_{c})-Nanokompositschicht zeigte sich überraschend, dass bei einem definierten Sauerstoffeinbau sehr hohe Härten mittels Vickersindenter bis 4000 HV [0.01] erreicht werden, sofern ein Sauerstoffgrenzwert c = 0,1 in der Nanokompositschicht nicht überschritten wird.

Überraschenderweise wurde festgestellt, dass bei der Verwendung der sauerstoffhaltigen Precursoren CO und/oder CO₂ Lamellenstrukturen auftreten, wenn ein SiCl₄/TiCl₄-Verhältnisses zwischen 4 und 7 eingestellt wird.

Nachstehend ist die Erfindung an Ausführungsbeispielen und Abbildungen näher erläutert. Die Abbildungen zeigen:
- Abb.1:: Röntgendiffraktogramm der mittels CVD-Verfahren ohne Plasmaanregung hergestellten (TiₓSi_{y})(CₐN_{b}O_{c}) - Nanokompositschicht gemäß Ausführungsbeispiel 1,
- Abb.2:: XPS-Spektrum mit aufgelöstem Si2p-Peak für die (TiₓSi_{y})(CaN_{b}O_{c})-Nanokompositschicht in Ausführungsbeispiel 1,
- Abb.3:: Röntgendiffraktogramm der mittels CVD hergestellten (TiₓSi_{y})(CaN_{b}O_{c})-Nanokompositschicht gemäß Ausführungsbeispiel 2.
- Abb.4:: XPS-Spektrum mit O1 s-Peak für die (TiₓSi_{y})(CₐN_{b}O_{c})-Nanokompositschicht in Ausführungsbeispiel 2,
- Abb.5:: TEM-Aufnahme der (TiₓSi_{y})(CₐN_{b}O_{c})-Nanokompositschicht (B) mit Lamellenstruktur und der darunterliegenden TiN-Schicht (A) gemäß Ausführungsbeispiel 3,
- Abb.6:: XPS-Spektrum mit aufgelöstem Si2p-Peak für die (TiₓSi_{y})(CₐN_{b}O_{c})-Nanokompositschicht in Ausführungsbeispiel 4.

### Ausführungsbeispiel 1

Auf WC/Co-Hartmetallwendeschneidplatten, die mit einem 5 µm dicken TiN/TiCN/TiN-Schichtsystem vorbeschichtet sind, wird eine siliziumreiche (TiₓSi_{y})(CₐN_{b}O_{c})-Nanokompositschicht mittels thermischen CVD-Verfahren als Deckschicht abgeschieden. Der Beschichtungsprozess wird in einem Heißwand-CVD-Reaktor mit einem Innendurchmesser von 75 mm durchgeführt. Die CVD-Beschichtung erfolgt mit einer Gasmischung aus 0,09 Vol.-% TiCl₄, 0,58 Vol.-% SiCl₄, 0,23 Vol.-% CH₃CN, 0,31 Vol.-% CO und 98,79 Vol.-% H₂. Die Abscheidungstemperatur beträgt 850°C und der Prozessdruck 6 kPa. Nach einer Beschichtungszeit von 90 min wird eine 4,5 µm dicke (TiₓSi_{y})(CₐN_{b}O_{c})-Schicht erhalten.

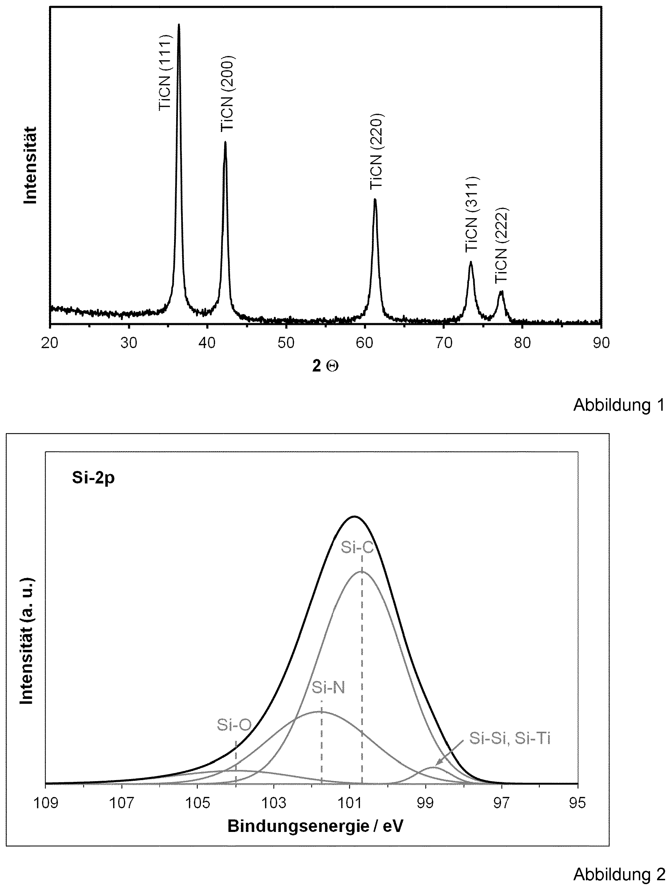

Aus dem Röntgendiffraktogramm in Abbildung 1 ist ersichtlich, dass bei der im streifenden Einfall durchgeführten röntgenographischen Dünnschichtanalyse nur eine kubische TiCₓN₁₋ₓ-Phase nachgewiesen wird. XPS-Untersuchungen ergaben, dass die kubische TiCₓN₁₋ₓ-Phase aus Titanoxykarbonitrid besteht. Das O1s-Spektrum weist einen breiten Peak zwischen 529 und 533 eV auf, der sowohl auf Ti-O- als auch Si-O-Bindungen zurückzuführen ist. Die Nanokompositschicht enthält als weitere Phase amorphes Siliziumoxykarbonitrid, das durch die in Abbildung 2 gezeigte XPS-Analyse nachgewiesen wurde.

Mittels Rietveld-Analyse wurde für die nanokristalline Titanoxykarbonitrid-Phase eine Kristallitgröße von 18,3 ± 1,8 nm ermittelt.

Die Elementanalyse mittels WDX ergab folgende Elementgehalte:
39,5 At.-% Ti,
9,7 At.-% Si,
27,2 At.-% C,
21,0 At.-% N,
2,1 At.-% O,
und 0,5 At.-% Cl.

Für diese (TiₓSi_{y})(CₐN_{b}O_{c})-Nanokompositschicht ergibt sich ein y-Wert von 0,2, der entsprechend y = Si/(Si + Ti) aus den Konzentrationen in At.-% errechnet wird. Aus der WDX-Elementanalyse ergibt sich eine Gesamtzusammensetzung für C, N, O mit a = 0,54, b = 0,42 und c = 0,04. Mittels Vickersindenter wurde eine Mikrohärte von 3590 HV [0,01] gemessen.

### Ausführungsbeispiel 2

Auf WC/Co-Hartmetallwendeschneidplatten, die mit einem 5 µm dicken TiN/TiCN/TiN-Schichtsystem vorbeschichtet sind, wird eine siliziumarme (TiₓSi_{y})(CₐN_{b}O_{c})-Nanokompositschicht mittels thermischen CVD-Verfahren als Deckschicht abgeschieden. Der Beschichtungsprozess wird in einem Heißwand-CVD-Reaktor mit einem Innendurchmesser von 75 mm durchgeführt. Die CVD-Beschichtung erfolgt mit einer Gasmischung aus 0,18 Vol.-% TiCl₄, 0,57 Vol.-% SiCl₄, 0,22 Vol.-% CH₃CN, 0,78 Vol.-% CO, 71,38 Vol.-% H₂ und 26,87 Vol.-% N₂ Die Abscheidungstemperatur beträgt 850°C und der Prozessdruck 6 kPa. Nach einer Beschichtungszeit von 90 min wird eine 6,9 µm dicke (TiₓSi_{y})(CₐN_{b}O_{c})-Schicht erhalten.

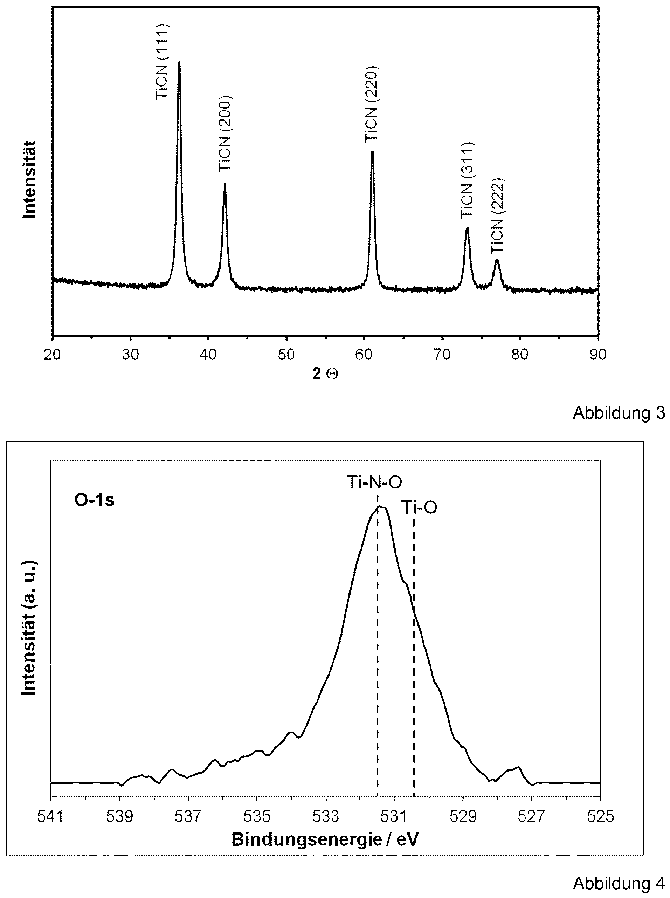

Bei der im streifenden Einfall durchgeführten röntgenographischen Dünnschichtanalyse wird nur eine kubische TiCₓN₁₋ₓ-Phase nachgewiesen, wie das in Abbildung 3 dargestellte Röntgendiffraktogramm zeigt. XPS-Untersuchungen ergaben, dass die kubische TiCₓN₁₋ₓ-Phase aus Titanoxykarbonitrid besteht. Das O1s-Spektrum weist gemäß Abbildung 4 einen breiten Peak zwischen 529 und 533 eV auf, der aufgrund des geringen Siliziumgehaltes der Schicht hauptsächlich auf Ti-O-Bindungen, aber auch auf Ti-N-O- bzw. Ti-C-O-Bindungen zurückzuführen ist.

Die Nanokompositschicht enthält als weitere Phase amorphes Siliziumoxykarbonitrid, das ebenfalls mittels XPS-Analyse nachgewiesen wurde. Mittels Rietveld-Analyse wurde für die nanokristalline Titanoxykarbonitrid-Phase eine Kristallitgröße von 16,8 ± 2,1 nm ermittelt.

Die Elementanalyse mittels WDX ergab folgende Elementgehalte:
43,2 At.-% Ti,
1,7 At.-% Si,
26,0 At.-% C,
25,4 At.-% N,
3,4 At.-% O und
0,3 At.-% Cl.

Für diese (TiₓSi_{y})(CₐN_{b}O_{c})-Nanokompositschicht ergibt sich ein y-Wert von 0,04, der entsprechend y = Si/(Si + Ti) aus den Konzentrationen in At.-% errechnet wird. Aus der WDX-Elementanalyse ergibt sich eine Gesamtzusammensetzung für C, N, O mit a = 0,47, für b = 0,46 und für c = 0,06. Mittels Vickersindenter wurde eine Mikrohärte von 3330 HV [0,01] gemessen.

### Ausführungsbeispiel 3

Auf WC/Co-Hartmetallwendeschneidplatten, die mit einem 5 µm dicken TiN/TiCN/TiN-Schichtsystem vorbeschichtet sind, wird eine (TiₓSi_{y})(CₐN_{b}O_{c})-Nanokompositschicht mittels des erfindungsgemäßen thermischen CVD-Verfahrens als Deckschicht abgeschieden. Der Beschichtungsprozess wird in einem Heißwand-CVD-Reaktor mit einem Innendurchmesser von 75 mm durchgeführt. Die CVD-Beschichtung erfolgt mit einer Gasmischung aus 0,09 Vol.-% TiCl₄, 0,58 Vol.-% SiCl₄, 0,22 Vol.-% CH₃CN, 0,31 Vol.-% CO, 71,5 Vol.-% H₂ und 27,3 Vol.-% N₂ Die Abscheidungstemperatur beträgt 850°C und der Prozessdruck 6 kPa.

Nach einer Beschichtungszeit von 90 min wird eine 4,1 µm dicke (TiₓSi_{y})(CₐN_{b}O_{c})-Nanokompositschicht erhalten.

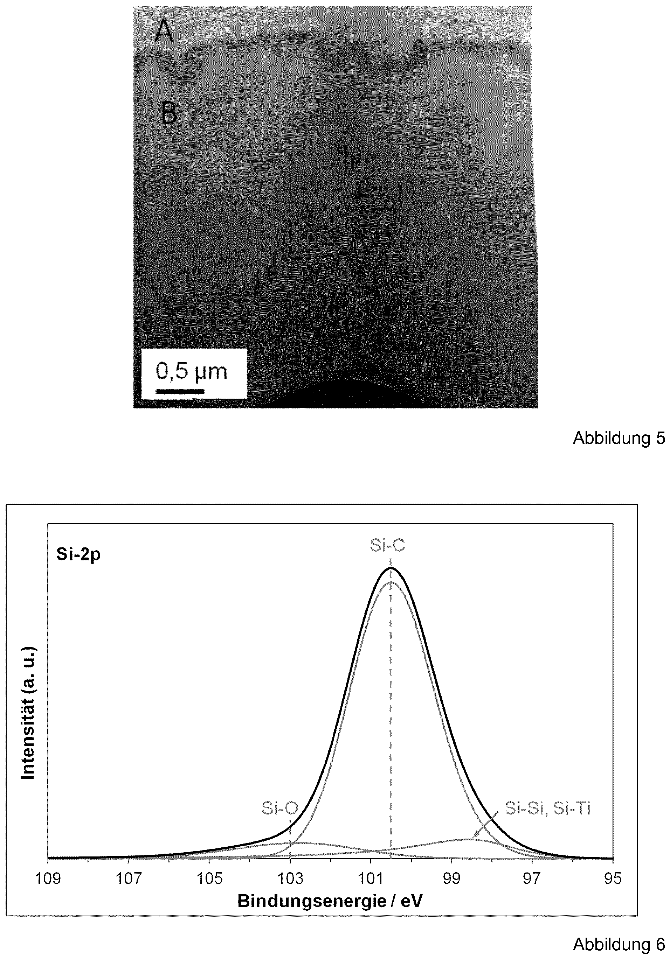

Abbildung 5 zeigt eine TEM-Aufnahme des Querschliffes einer (TiₓSi_{y})(CₐN_{b}O_{c})-Nanokompositschicht, die eine Lamellenstruktur aufweist, die bei der Einstellung eines SiCl₄/TiCl₄-Verhältnisses zwischen 4 und 7 erzeugt wird. In den Lamellen liegen unterschiedliche Si/Ti-Atomverhältnisse vor, die durch einen EDX-Linescan nachweisbar sind. Bei der im streifenden Einfall durchgeführten röntgenographischen Dünnschichtanalyse wird nur eine kubische TiCₓN₁₋ₓ-Phase nachgewiesen. Silicium ist in einer zweiten amorphen Siliziumoxykarbonitrid-Phase enthalten. Mittels Rietveld-Analyse wurde für die nanokristalline Titanoxykarbonitrid-Phase eine Kristallitgröße von 17,0 ± 2,7 nm ermittelt.

Die Elementanalyse mittels WDX ergab folgende Elementgehalte:
42,1 At.-% Ti,
4,7 At.-% Si,
26,7 At.-% C,
23,7 At.-% N,
2,7 At.-% O und
0,1 At.-% Cl.

Für diese (TiₓSi_{y})(CₐN_{b}O_{c})-Nanokompositschicht ergibt sich ein y-Wert von 0,1, der entsprechend y =Si/(Si + Ti) aus den Konzentrationen in At.-% errechnet wird. Aus der WDX-Elementanalyse ergibt sich eine Gesamtzusammensetzung für C, N, O mit a = 0,50, für b = 0,45 und für c = 0,05. Mittels Vickersindenter wurde eine Mikrohärte von 3410 HV [0,01] gemessen.

### Ausführungsbeispiel 4

Auf WC/Co-Hartmetallwendeschneidplatten, die mit einem 5 µm dicken TiN/TiCN/TiN-Schichtsystem vorbeschichtet sind, wird eine (TiₓSi_{y})(CₐN_{b}O_{c})-Nanokompositschicht mittels thermischen CVD-Verfahrens als Deckschicht abgeschieden. Der Beschichtungsprozess wird in einem Heißwand-CVD-Reaktor mit einem Innendurchmesser von 75 mm durchgeführt. Die CVD-Beschichtung erfolgt mit einer Gasmischung aus 0,12 Vol.-% TiCl₄, 0,58 Vol.-% SiCl₄, 0,22 Vol.-% CH₃CN, 0,59 Vol.-% CO, 71,36 Vol.-% H₂ und 27,13 Vol.-% N₂ Die Abscheidungstemperatur beträgt 850°C und der Prozessdruck 6 kPa. Nach einer Beschichtungszeit von 90 min wird eine 4,4 µm dicke (TiₓSi_{y})(CₐN_{b}O_{c})-Schicht erhalten.

Bei der im streifenden Einfall durchgeführten röntgenographischen Dünnschichtanalyse wird nur eine kubische TiCₓN₁₋ₓ-Phase nachgewiesen. XPS-Untersuchungen ergaben, dass die kubische TiCₓN₁₋ₓ-Phase aus Titanoxykarbonitrid besteht. Die Nanokompositschicht enthält als weitere Phase amorphes Siliziumoxykarbid, dass durch die in Abbildung 6 gezeigte XPS-Analyse nachgewiesen wurde. Mittels Rietveld-Analyse wurde für die nanokristalline Titanoxykarbonitrid-Phase eine Kristallitgröße von 14,0 ± 2,1 nm ermittelt.

Die Elementanalyse mittels WDX ergab folgende Elementgehalte:
42,5 At.-% Ti,
2,7 At.-% Si,
25,5 At.-% C,
26,2 At.-% N,
2,9 At.-% O und
0,2 At.-% Cl.

Für diese (TiₓSi_{y})(CₐN_{b}O_{c})-Nanokompositschicht ergibt sich ein y-Wert von 0,06, der entsprechend y = Si/(Si+Ti) aus den Konzentrationen in At.-% errechnet wird. Aus der WDX-Elementanalyse ergibt sich eine Gesamtzusammensetzung für C, N, O mit a = 0,47, für b = 0,48 und für c = 0,05. Mittels Vickersindenter wurde eine Mikrohärte von 3410 HV [0,01] gemessen.

## Patentansprüche

1. Verfahren zur Herstellung hartstoffbeschichteter Körper aus Metall, Hartmetall, Cermet oder Keramik, bei dem mittels eines thermischen CVD-Verfahrens ohne Plasmaanregung mindestens eine (TiₓSi_{y})(CₐN_{b}O_{c})-Nanokompositschicht in einer Gasmischung aus TiCl₄, einem oder mehreren Siliziumchloriden, CH₃CN, H₂ und eines Gaszusatzes von CO und/oder CO₂ und bei Temperaturen zwischen 700°C und 950°C und bei Drücken zwischen 0,1 kPa und 0,1 MPa abgeschieden wird, wobei ein Atomverhältnis Si/Ti der Silizium- und Titanchloride in der Gasphase größer 1 gewählt wird.

2. Verfahren nach Anspruch 1, bei dem der Gasmischung N₂ zugegeben wird.

3. Hartstoffbeschichtete Körper aus Metall, Hartmetall, Cermet oder Keramik, die mittels eines thermischen CVD-Verfahrens ohne Plasmaanregung mit einem ein- oder mehrlagigen Schichtsystem beschichtet sind, wobei das ein- oder mehrlagige Schichtsystem mindestens eine Nanokompositschicht mit einer Gesamtzusammensetzung (TiₓSi_{y})(CₐN_{b}O_{c}) mit 0,7 < x ≤ 0,99 und 0,01 ≤ y < 0,3 und 0,4 < a < 0,9 und 0,1 < b < 0,6 und 0,01 < c ≤ 0,1 mit x+y=1 und a+b+c=1 enthält, wobei die Nanokompositschicht eine erste nanokristalline Phase aus kubischem Titanoxykarbonitrid und eine zweite amorphe Phase aus Siliziumoxykarbonitrid oder Siliziumoxykarbid aufweist, wobei Ti-O- und Si-O-Bindungen ausgebildet sind, und wobei die erste nanokristalline Phase aus kubischem Titanoxykarbonitrid eine Kristallitgröße von 10 nm bis 20 nm aufweist, und wobei die Nanokompositschicht einen Chlorgehalt zwischen 0,001 und 1 At.-% aufweist.

4. Hartstoffbeschichtete Körper nach Anspruch 3, bei denen mehrere Nanokompositschichten angeordnet sind.

5. Hartstoffbeschichtete Körper nach Anspruch 3, bei denen die eine oder mehrere Nanokompositschichten einen Gradienten hinsichtlich des Si/Ti-Atomverhältnisses aufweisen.

6. Hartstoffbeschichtete Körper nach Anspruch 3, bei denen mindestens eine Nanokompositschicht eine lamellare Struktur besitzt.

7. Hartstoffbeschichtete Körper nach Anspruch 3, bei denen die Schicht mit lamellarer Struktur Lamellen mit einer Dicke zwischen 50 nm und 500 nm aufweist.

8. Hartstoffbeschichtete Körper nach Anspruch 3, bei denen die Schicht mit lamellarer Struktur Lamellen mit unterschiedlichen Si/Ti-Atomverhältnissen aufweist.

9. Hartstoffbeschichtete Körper nach Anspruch 3, bei denen die Nanokompositschicht eine Härte von 3000 HV bis 4000 HV, vorteilhafterweise ein Härte von 3300 HV bis 3600 HV aufweist.

10. Hartstoffbeschichtete Körper nach Anspruch 3, bei denen die Nanokompositschicht eine Schichtdicke von 1 µm bis 10 µm, vorteilhafterweise eine Schichtdicke von 4 µm bis 7 µm aufweist.

11. Hartstoffbeschichtete Körper nach Anspruch 3, bei denen eine oder mehrere Deckschichten und/oder Anbindungsschichten vorhanden sind.

12. Hartstoffbeschichtete Körper nach Anspruch 11, bei denen die Deckschichten und/oder Anbindungsschichten aus einem oder mehreren Nitriden, Karbiden, Karbonitriden, Oxynitriden, Oxykarbiden, Oxykarbonitriden, Oxiden von Ti, Hf, Zr, Cr und/oder Al oder Mischphasen dieser Elemente bestehen.

## Claims

1. Process for producing hard material-coated bodies composed of metal, cemented hard material, cermet or ceramic, wherein at least one (TiₓSi_{y}) (CₐN_{b}O_{c}) nanocomposite layer is deposited by means of a thermal CVD process without plasma excitation in a gas mixture composed of TiCl₄, one or more silicon chlorides, CH₃CN, H₂ and of a gas addition of CO and/or CO₂ and at temperatures in the range from 700°C to 950°C and at pressures in the range from 0.1 kPa to 0.1 MPa, where an atomic ratio Si/Ti of the silicon chlorides and titanium chlorides in the gas phase of greater than 1 is selected.

2. Process according to Claim 1, wherein N₂ is added to the gas mixture.

3. Hard material-coated bodies composed of metal, cemented hard material, cermet or ceramic and coated with a single-layer or multilayer layer system by means of a thermal CVD process without plasma excitation, wherein the single-layer or multilayer layer system contains at least one nanocomposite layer having an overall composition (TiₓSi_{y}) (CₐN_{b}O_{c}) with 0.7 < × ≤ 0.99 and 0.01 ≤ y < 0.3 and 0.4 < a < 0.9 and 0.1 < b < 0.6 and 0.01 < c ≤ 0.1 with x+y=1 and a+b+c=1, wherein the nanocomposite layer comprises a first nanocrystalline phase composed of cubic titanium oxycarbonitride and a second amorphous phase composed of silicon oxycarbonitride or silicon oxycarbide, wherein Ti-O bonds and Si-O bonds have been formed and wherein the first nanocrystalline phase composed of cubic titanium oxycarbonitride has a crystallite size of from 10 nm to 20 nm and wherein the nanocomposite layer has a chlorine content in the range from 0.001 to 1 at%.

4. Hard material-coated bodies according to Claim 3, wherein a plurality of nanocomposite layers are arranged.

5. Hard material-coated bodies according to Claim 3, wherein the one or more nanocomposite layers have a gradient in respect of the Si/Ti atomic ratio.

6. Hard material-coated bodies according to Claim 3, wherein at least one nanocomposite layer has a lamellar structure.

7. Hard material-coated bodies according to Claim 3, wherein the layer having a lamellar structure comprises lamellae having a thickness in the range from 50 nm to 500 nm.

8. Hard material-coated bodies according to Claim 3, wherein the layer having a lamellar structure comprises lamellae having different Si/Ti atomic ratios.

9. Hard material-coated bodies according to Claim 3, wherein the nanocomposite layer has a hardness of from 3000 HV to 4000 HV, advantageously a hardness of from 3300 HV to 3600 HV.

10. Hard material-coated bodies according to Claim 3, wherein the nanocomposite layer has a layer thickness of from 1 µm to 10 µm, advantageously a layer thickness of from 4 µm to 7 µm.

11. Hard material-coated bodies according to Claim 3, wherein one or more covering layers and/or bonding layers are present.

12. Hard material-coated bodies according to Claim 11, wherein the covering layers and/or bonding layers consist of one or more nitrides, carbides, carbonitrides, oxynitrides, oxycarbides, oxycarbonitrides, oxides of Ti, Hf, Zr, Cr and/or Al or mixed phases of these elements.

## Revendications

1. Procédé pour la préparation de corps composés de métal, de métal dur, de cermet ou de céramique, revêtus par des matériaux durs, dans lequel, au moyen d'un procédé de CVD thermique sans excitation du plasma, au moins une couche de nanocomposite de (TiₓSi_{y}) (CₐN_{b}O_{c}) est déposée, dans un mélange de gaz composé de TiCl₄, d'un ou plusieurs chlorures de silicium, de CH₃CN, de H₂ et d'un ajout de gaz de CO et/ou de CO₂ et à des températures comprises entre 700 °C et 950 °C et à des pressions comprises entre 0,1 kPa et 0,1 MPa, un rapport atomique Si/Ti des chlorures de silicium et de titane dans la phase gazeuse étant choisi supérieur à 1.

2. Procédé selon la revendication 1, dans lequel du N₂ est ajouté au mélange de gaz.

3. Corps composés de métal, de métal dur, de cermet ou de céramique, revêtus par des matériaux durs, qui sont revêtus avec un système de couches monocouche ou multicouche au moyen d'un procédé de CVD thermique sans excitation du plasma, le système de couches monocouche ou multicouche contenant au moins une couche de nanocomposite dotée d'une composition globale (TiₓSi_{y}) (CₐN_{b}O_{c}) avec 0,7 < x ≤ 0,99 et 0,01 ≤ y < 0,3 et 0,4 < a < 0,9 et 0,1 < b < 0,6 et 0,01 < c ≤ 0,1 avec x + y = 1 et a + b + c = 1, la couche de nanocomposite présentant une première phase nanocristalline composée d'oxycarbonitrure de titane cubique et une deuxième phase amorphe composée d'oxycarbonitrure de silicium ou d'oxycarbure de silicium, des liaisons Ti-O- et des liaisons Si-O- étant formées, et la première phase nanocristalline composée d'oxycarbonitrure de titane cubique présentant une taille de cristallite de 10 nm à 20 nm, et la couche de nanocomposite présentant une teneur en chlore comprise entre 0,001 et 1 % en atomes.

4. Corps revêtus par des matériaux durs selon la revendication 3, dans lesquels plusieurs couches de nanocomposite sont disposées.

5. Corps revêtus par des matériaux durs selon la revendication 3, dans lesquels une ou plusieurs couches de nanocomposite présentent un gradient en ce qui concerne le rapport atomique Si/Ti.

6. Corps revêtus par des matériaux durs selon la revendication 3, dans lesquels au moins une couche de nanocomposite possède une structure lamellaire.

7. Corps revêtus par des matériaux durs selon la revendication 3, dans lesquels la couche comportant une structure lamellaire présente des lamelles dotées d'une épaisseur comprise entre 50 nm et 500 nm.

8. Corps revêtus par des matériaux durs selon la revendication 3, dans lesquels la couche comportant une structure lamellaire présente des lamelles dotées de rapports atomiques Si/Ti différents.

9. Corps revêtus par des matériaux durs selon la revendication 3, dans lesquels la couche de nanocomposite présente une dureté de 3 000 HV à 4 000 HV, avantageusement une dureté de 3 300 HV à 3 600 HV.

10. Corps revêtus par des matériaux durs selon la revendication 3, dans lesquels la couche de nanocomposite présente une épaisseur de couche de 1 µm à 10 µm, avantageusement une épaisseur de couche de 4 µm à 7 µm.

11. Corps revêtus par des matériaux durs selon la revendication 3, dans lesquels une ou plusieurs couches supérieures et/ou couches de liaison sont présentes.

12. Corps revêtus par des matériaux durs selon la revendication 11, dans lesquels les couches supérieures et/ou les couches de liaison sont constituées d'un ou plusieurs nitrures, carbures, carbonitrures, oxynitrures, oxycarbures, oxycarbonitrures, oxydes de Ti, de Hf, de Zr, de Cr et/ou d'Al ou de phases mixtes de ces éléments.
